# EUROPEAN PATENT APPLICATION

(11) **EP 4 593 288 A1**
(43) Date of publication of application: **30.07.2025**
(21) Application number: 24460007.8
(22) Date of filing: 25.01.2024
(51) Int. Cl.: H03K 17/10, H02M 1/34, H03K 17/16, H03K 17/74, H02M 1/088

(54) **HV SWITCH UNIT, PULSING ASSEMBLY AND METHOD OF AVOIDING VOLTAGE IMBALANCES IN AN HV SWITCH**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

HV switch unit (1, 10, 100, 101, 102) comprising:
a. several semiconductor switches (S1, Si, Sn) connected in series and configured to switch on and off simultaneously,
b. series circuits (2, 3, 4, 2', 3', 4') of a snubber energy storage component (C11, Ci1.. Cn1) and a snubber rectifying component (D11, Di1, On1), wherein a series circuit (2, 3, 4, 2', 3', 4') is connected parallel to each semiconductor switch (S1, Si, Sn),
c. a voltage balancing circuit (5, 5') comprising a chain of balancing, in particular rectifying components (D12, Di2) in combination with one voltage limiting electronic component (Vlimit, Vlimit'), wherein:
i. the balancing electronic components (D12, Di2) are connected between the connection points of the snubber energy storage component (C1, Ci, Cn) and the snubber rectifying component (D11, Di1, On1) of series circuits (2, 3, 4, 2', 3', 4') associated with neighboring semiconductor switches (S1, Si, Sn),
ii. the balancing electronic components (D12, Di2) form a chain parallel to the series connected semiconductor switches (S1, Si, Sn), wherein the chain is configured to transport electrical charge from one snubber energy storage component (C11, Ci1.. Cn1) to the next only in one direction,
iii. the voltage limiting electronic component (Vlimit, Vlimit') is configured to limit the voltage at the end of the chain, whereby the HV switch unit comprises
iv. at least a combination of one resistor (R12, Ri2, Rn2) and one inductivity (L12, Li2, Ln2).

## Description

### Background of the invention

The invention relates to an HV switch unit comprising several semiconductor switches connected in series and configured to switch on and off simultaneously.

Imperfect driver synchronization, parasitic circuit components as well as small deviations of the properties of the semiconductors, which are connected in series to operate as one HV switch, may cause significant voltage imbalance among the individual semiconductor switches and lead to failure due to overvoltage or thermal overload.

The higher the voltage and/or switching frequency the more significant this problem becomes.

One solution is to place clamp-and-discharge circuits locally on each semiconductor switch. A diode and capacitor can provide fast clamping, and the discharge feature can be achieved by an active voltage limiter.

This solution requires equipping each semiconductor switch with a voltage-limiter circuit (which consists of several components) although only some of these limiters will be used efficiently.

In CN203504399U is disclosed serial-connection voltage limiting circuit for power switch device. The circuit comprises a plurality of power switch devices from Q1 to Qn which are connected in a serial manner, a plurality of energy storage circuit from P1 to Pm, a plurality of discharging diodes Dp, a plurality of convergence diodes Dq, an energy concentration diode Du and an adjustable voltage limiter U. The device handles a voltage limiting circuit but does not solve the imbalance matter.

### Object of the invention

It is an object of the invention to provide an HV switch unit that does not suffer from voltage imbalances.

### Description

According to a first aspect of the invention this object is solved by an HV switch unit comprising:
a. several semiconductor switches connected in series and configured to switch on and off simultaneously,
b. series circuits of a snubber energy storage component and a snubber rectifying component, wherein a series circuit is connected parallel to each semiconductor switch,
c. a voltage balancing circuit comprising a chain of balancing, in particular rectifying, electronic components, in combination with one voltage limiting electronic component, wherein
   i. the balancing electronic components are connected between the connection points of the snubber energy storage component and the snubber rectifying component of series circuits associated with neighboring semiconductor switches,
   ii. the balancing electronic components form a chain parallel to the series connected semiconductor switches, wherein the chain is configured to transport electrical charge from one snubber energy storage component to the next only in one direction,
   iii. the voltage limiting electronic component is configured to limit the voltage at the end of the chain, whereby the HV switch unit comprises
   iv. at least a combination of one resistor and one inductivity.

Thus, a chain of balancing electronic components, in particular a diode chain, is used to spread the excessive charge from local energy storage components along the serial switches to an energy storing component at the end of the chain, in particular the top-most or bottom-most energy storage component. Only one voltage limiting component may be required, which may be located at one end of the chain.

Every time the HV switch, i.e. the several semiconductor switches, is turned on the (diode) chain is activated and voltages on the energy storage components are equalized.

The inventive concept improves the even voltage distribution among multiple semiconductor switches, which are connected in series to form an HV switch. In particular, differential energy dissipation among all switches is ensured. The inventive concept can be applied for soft switching devices (no current before switch-off).

A combination of resistor and inductivity may be connected in series to at least one, in particular each, snubber rectifying component. Such a combination causes the voltage equalization time to be longer and the switch-on phase can be shorter.

A combination of resistor and inductivity may be connected to at least one, in particular each, snubber energy storage component. Such a resistor and an inductivity can dissipate power and protect the circuit.

As mentioned, the chain comprises at least a combination of one resistor and one inductivity. Such a combination limits the current at the beginning of the switch-on phase of the switch. As a result, a reduction of an energy loss in the circuit is possible.

An input port of the HV switch unit may be configured to be connected to a power source, which may be a DC voltage source. The HV switch may be configured to switch on and off a DC voltage with an absolute value of 500 V or more, in particular 1.000 V or more. Furthermore, the HV switch may be configured to switch on or off within a rising time of 1 ms or less.

A second series circuit of a snubber energy storage component and a snubber rectifying component may be connected parallel to each semiconductor switch, and a second voltage balancing circuit comprising a series connection of balancing electronic components in combination with at least one voltage limiting electronic component may be provided, wherein:
a. the balancing electronic components are connected between the connection points of the snubber energy storage component and the snubber rectifying component of the second series circuits associated with neighboring semiconductor switches
b. the balancing electronic components form a chain parallel to the HV switch, wherein the chain is configured to transport electrical charge from one snubber energy storage component to the next only in one direction.

Thus, a second chain is provided and each chain can transport electrical charge in another direction. Hence, bidirectional balancing may be realized, improving the balancing performance.

The voltage limiting electronic component may comprise a voltage detection component, in particular a Zener diode or any other circuit that consumes energy when voltage on it is higher than a reference voltage. In particular, an overvoltage may be detected by the voltage detection circuit which then leads to power dissipation in a power transistor which may be triggered by the voltage detection component. As a result, the voltage at the snubber energy storage component at the end of a chain is limited. The voltage limiting electronic component may comprise a recuperation circuit to transfer energy back to a power source.

The first or last switch may be placed on a stable potential and the voltage limiting element may be placed in the vicinity of the switch placed on the stable potential. Such a switch is usually at the end of the chain of transistors which make up the HV switch. A stable potential may be earth or ground e.g. it may be also any potential which is above or below earth or ground and does not change its voltage in respect to earth or ground over a predetermined period.

In a further aspect the invention relates to a pulsing assembly for supplying voltage pulses to a load, in particular a plasma process, the assembly having an input port for connection to a power source and an output port for connection to the load. The pulsing assembly comprises a first HV switch unit according to the invention connected between the input port and the output port and/or a second HV switch unit according to the invention connected between the output port and a common port, configured to be connected to ground. Such a pulsing assembly can be used to supply a plasma process with energy in the form of voltage pulses, for example for plasma etching or plasma deposition of material on a substrate. However, other fields of use exist for an inventive pulsing assembly.

The pulsing assembly may be configured to supply pulses with a voltage corresponding to the DC-voltage at the input port. In particular, the pulsing assembly may be configured to supply pulses with a duration of 1 ms or less.

In another aspect the invention relates to a method of avoiding voltage imbalances in an HV switch consisting of several semiconductor switches connected in series when the HV switch is turned on, comprising the steps of:
a. Connecting in parallel to each semiconductor switch a series circuit of a snubber energy storage component and a snubber rectifying component,
b. Spreading the excess charge from the energy storage components by providing a chain of balancing electronic components parallel to the semi-conductor switches,
c. Limiting the voltage at the beginning or end of the chain by providing a voltage limiting electronic component in parallel to the snubber energy storage component associated with the first or last semiconductor switch of the series connected semiconductor switches
d. dissipating differential power by providing at least a combination of one resistor and one inductivity.

The excess charge may be spread in one direction only or a second series circuit of a snubber energy storage component and a snubber rectifying component may be provided for each semiconductor switch and a second chain of balancing electronic components may be provided, wherein each chain spreads charge in one direction only.

Two HV switches may be connected in series, the series connection may be connected to a DC source, an output port at the connection point of the HV switches may be connected to a plasma load and the HV switches may be controlled such that a pulsed voltage is supplied to a load, in particular a plasma load.

### Short description of the drawing

- Fig. 1: shows a first embodiment of an HV switch unit transporting charge in a first direction;
- Fig. 2: shows a second embodiment of an HV switch unit transporting charge in a first direction;
- Fig. 3: shows a third embodiment of an HV switch unit transporting charge in a second direction;
- Fig. 4: shows a fourth embodiment of an HV switch unit transporting charge in a second direction;
- Fig. 5: shows a fifth embodiment of an HV switch unit transporting charge in two directions;
- Fig. 6: shows a sixth embodiment of an HV switch unit transporting charge in two directions;
- Fig. 7: shows a pulsing assembly.

### Detailed description of the invention and drawing

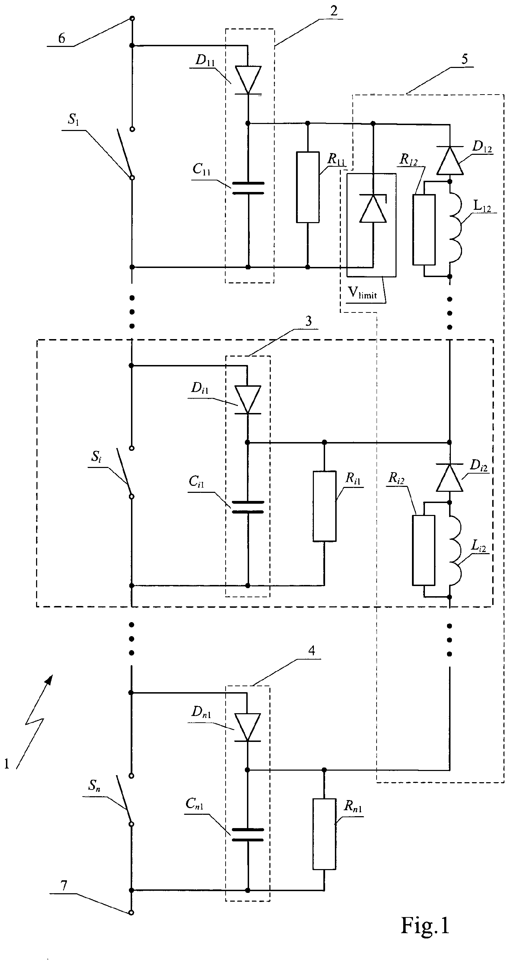

Fig. 1 shows a first embodiment of an HV switch unit 1. The HV switch unit 1 comprises several semiconductor switches S1, Si, Sn connected in series and configured to switch on and off simultaneously. Parallel to each semiconductor switch S1, Si, Sn is provided a series circuit 2, 3, 4 of a snubber energy storage componentC11, Ci1, Cn1, in this case embodied as a capacitor, and a snubber rectifying component D11, Di1, Dn1, in this case embodied as a diode.

A voltage balancing circuit 5 comprises a chain of balancing, in particular rectifying components D12, Di2, in this case embodied as diodes. The voltage balancing circuit 5 further comprises one voltage limiting electronic component Vlimit. The chain of the voltage balancing circuit 5 further comprises resistors R12, Ri2 and inductivities L12, Li2. The balancing components D12, Di2 and the parallel connected resistors R12, Ri2 and inductivities L12, Li2 are connected between the connection points of the snubber energy storage component C11, Ci1, Cn1 and the snubber rectifying component D11, Di1, Dn1 of series circuits 2, 3, 4 associated with neighboring semiconductor switches S1, Si, Sn. In other words, a series arrangement of a balancing component D12, Di2 and a resistor R12, Ri2 and inductivity L12, Li2 connects two neighboring series circuits 2, 3, 4. The series arrangements are themselves connected in series.

The balancing components D12, Di2 are forming a chain parallel to the series connected semiconductor switches S1, Si, Sn, wherein the chain is configured to transport electrical charge from one snubber energy storage component C11, Ci1, Cn1 to the next only in one direction. In the embodiment shown charge is transported from snubber energy storage component Cn1 to snubber energy storage component Ci1 and from snubber energy storage component Ci1 to snubber energy storage component C11.

The voltage limiting electronic component Vlimit is configured to limit the voltage at the end of the chain, where the electrical charge or energy is transported to. To this end the voltage limiting electronic component Vlimit comprises a voltage detection component, in particular a Zener diode, or any other circuit that detects a voltage rising above a reference voltage, and a consumer to consume energy when the voltage detected is higher than the reference voltage. The consumer may be a transistor. The consumer may be a circuit, such as an inverter, feeding energy back into a part of an external circuit or component such as an energy storage component such as a capacitor, e.g..

Resistors R11, Ri1, Rn1 are connected in parallel to each snubber energy storage component C11, Ci1, Cn1.

Ports 6, 7 are provided, at least one of the ports 6, 7 being connectable to a power source, in particular a DC power source.

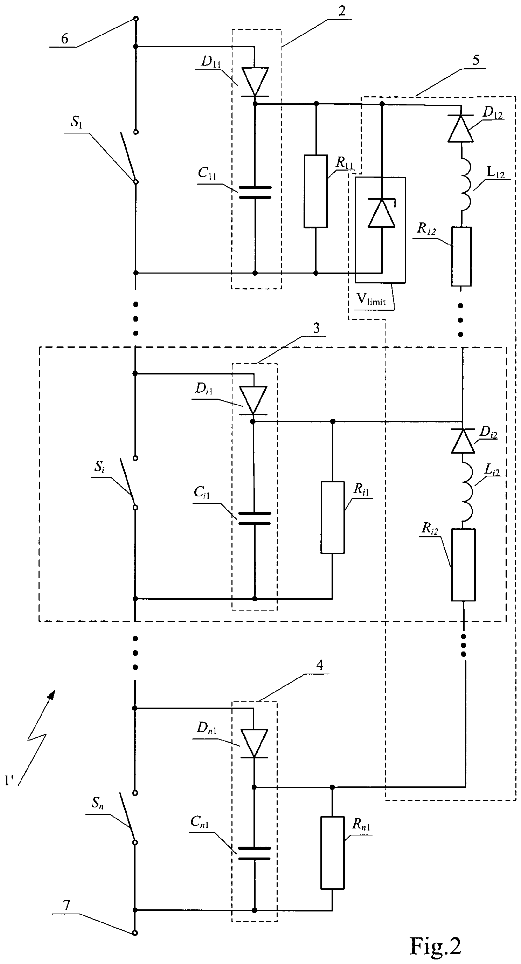

The HV switch unit 1' shown in Fig. 2 corresponds to the HV switch unit 1 of Fig. 1 with the difference that balancing element D12, resistor R12 and inductivity L12 are connected in series and also balancing element Di2, resistor Ri2 and inductivity Li2 are connected in series.

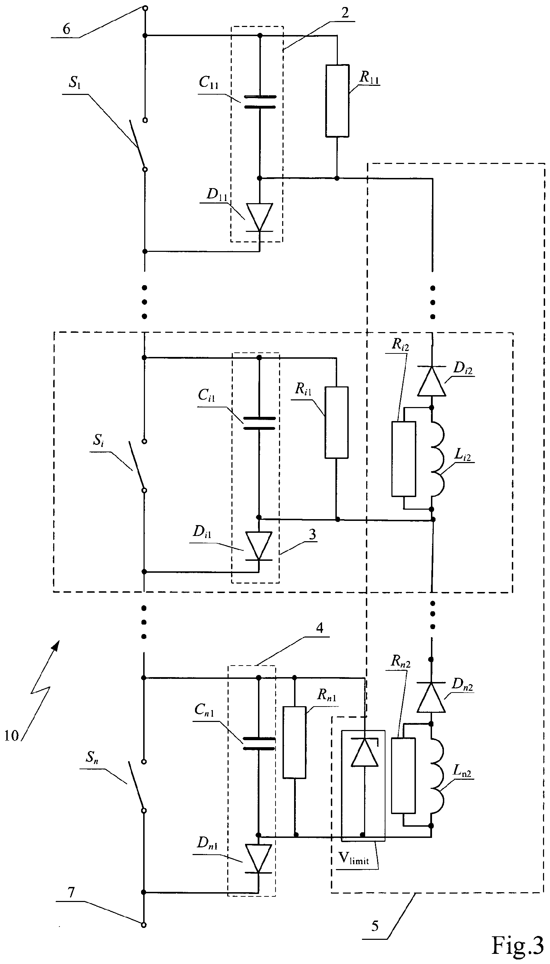

The HV switch unit 10 shown in Fig. 3 corresponds to the HV switch unit 1 of Fig. 1 except that the order of the components of the series circuits 2, 3, 4 is reversed and the voltage limiting electronic component Vlimit is at the other end of the voltage balancing circuit 5. In particular the voltage limiting electronic component is connected parallel to snubber energy storage component Cn1 and resistor Rn 1.

In the embodiment shown in Fig. 3 the charge is transferred from snubber energy storage component C11 to snubber energy storage component Ci1 and from snubber energy storage component Ci1 to snubber energy storage component Cn1.

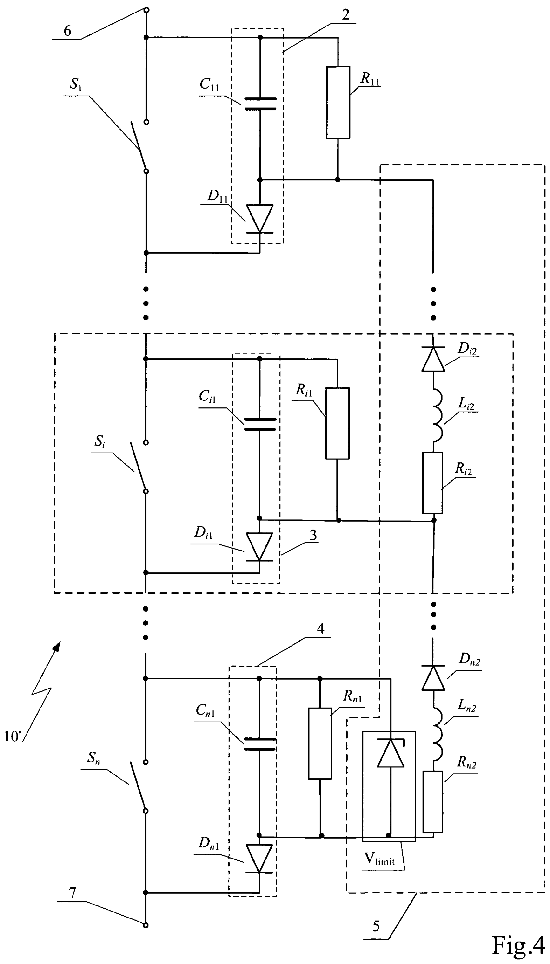

The HV switch unit 10' shown in Fig. 4 corresponds to the HV switch unit 10 of Fig. 3 with the difference that balancing element Di2, resistor Ri2 and inductivity Li2 are connected in series and also balancing element Dn2, resistor Rn2 and inductivity Ln2 are connected in series.

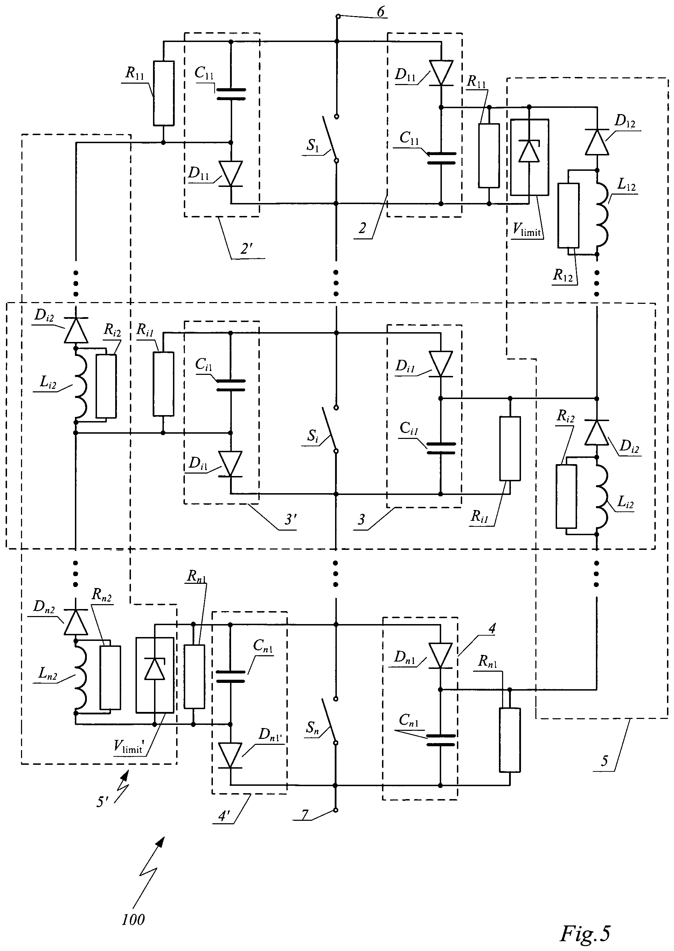

Fig. 5 is a combination of the embodiments shown in Fig. 1 and Fig. 3. The HV switch unit 100 shown in Fig. 5 comprises a first and a second voltage balancing circuit 5, 5' and a first and second series circuit 2, 3, 4, 2', 3', 4' is provided for each switch S1, Si, Sn.

In first voltage balancing circuit 5 charge is transferred upwards to snubber energy storage component C11 and excess energy is consumed in voltage limiting component Vlimit. In voltage balancing circuit 5' charge is transferred to snubber energy storage component Cn1', i.e. downwards and excess energy is consumed in voltage limiting component Vlimit'.

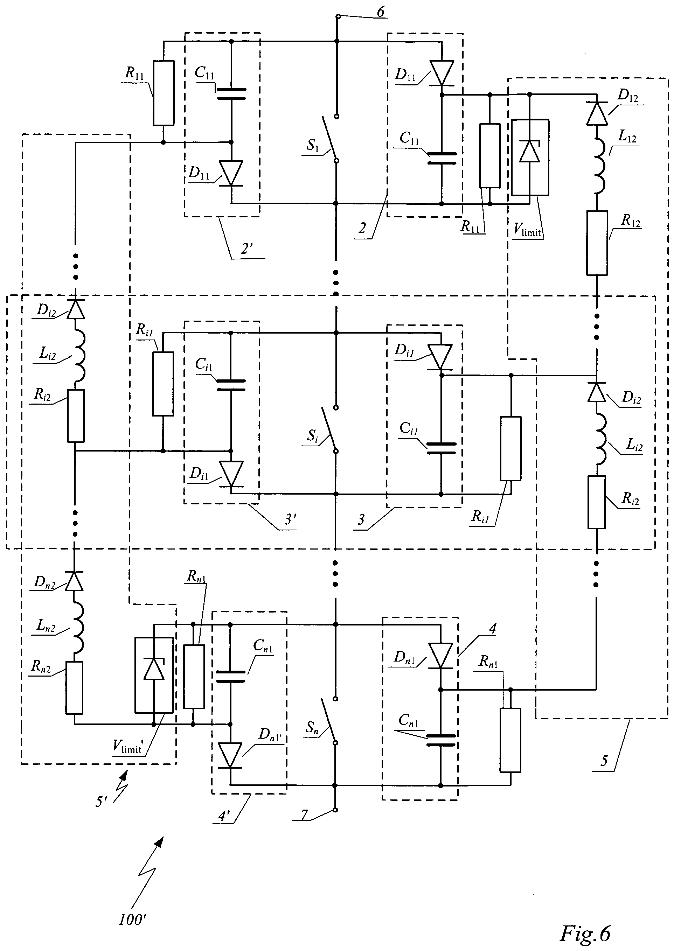

The HV switch unit 100' shown in Fig. 6 corresponds to the HV switch unit 100 of Fig. 5 with the difference that the HV switch unit 100' is a combination of the embodiments shown in Fig. 2 and Fig. 4.

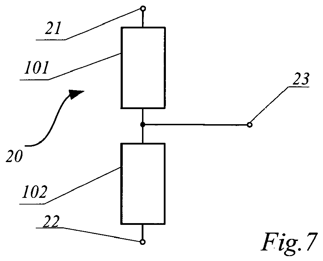

Fig. 7 shows a pulsing assembly 20 having a series connection of two HV switch units 101, 102. Each of the HV switch units 101, 102 can be embodied as one of the HV switch units 1, 1', 10, 10', 100, 100'.

The pulsing assembly has ports 21, 22 for connection to a power source, in particular a DC power source. An output port 23 is connected to a connection point of the HV switch units 101, 102. A pulsed voltage can be output at port 23 and supplied to a load, for example a plasma load.

## Claims

1. HV switch unit (1, 1', 10, 10', 100, 100', 101, 102) comprising:
a. several semiconductor switches (S1, Si, Sn) connected in series and configured to switch on and off simultaneously,
b. series circuits (2, 3, 4, 2', 3', 4') of a snubber energy storage component (C11, Ci1.. Cn1) and a snubber rectifying component (D11, Di1, Dn1), wherein a series circuit (2, 3, 4, 2', 3', 4') is connected parallel to each semiconductor switch (S1, Si, Sn),
c. a voltage balancing circuit (5, 5') comprising a chain of balancing, in particular rectifying components (D12, Di2, Dn2) in combination with one voltage limiting electronic component (Vlimit, Vlimit'), wherein
i. the balancing electronic components (D12, Di2, Dn2) are connected between the connection points of the snubber energy storage component (C11, Ci1, Cn1) and the snubber rectifying component (D11, Di1, Dn1) of series circuits (2, 3, 4, 2', 3', 4') associated with neighboring semiconductor switches (S1, Si, Sn),
ii. the balancing electronic components (D12, Di2, Dn2) form a chain parallel to the series connected semiconductor switches (S1, Si, Sn), wherein the chain is configured to transport electrical charge from one snubber energy storage component (C11, Ci1.. Cn1) to the next only in one direction,
iii. the voltage limiting electronic component (Vlimit, Vlimit') is configured to limit the voltage at the end of the chain, **characterized in that** the HV switch unit (1, 1', 10, 10', 100, 100') comprises further:
iv. at least a combination of one resistor (R12, Ri2, Rn2) and one inductivity (L12, Li2, Ln2).
HV switch unit according to claim 1, wherein an energy consuming or dissipating element, in particular a resistor (R11, Ri1, Rn1) connected in series with an inductivity (L12, Li2,Ln2) is connected in parallel to at least one, in particular each, snubber energy storage component (C11, Ci1, Cn1).

2. HV switch unit according to claim 1, wherein an input port (6, 7) is configured to be connected to a power source, in particular a DC voltage source.

3. HV switch unit according to any of the preceding claims, wherein a second series circuit (2, 3, 4, 2', 3', 4') of a snubber energy storage component (C11, Ci1, Cn1) and a snubber rectifying component (D11, Di1, Dn1) is connected parallel to each semiconductor switch (S1, Si, Sn), and a second voltage balancing circuit (5, 5') comprising a series connection of balancing electronic components (D12, Di2, Dn2) in combination with at least one voltage limiting electronic component is provided, wherein
a. the balancing electronic components (D12, Di2, Dn2) are connected between the connection points of the snubber energy storage component (C11, Ci1, Cn1) and the snubber rectifying component (D11, Di1, Dn1) of the second series circuits (2, 3, 4, 2', 3', 4') associated with neighboring semiconductor switches (S1, Si, Sn)
b. the balancing electronic components (D12, Di2, Dn2) form a chain parallel to the HV switch unit, wherein the chain is configured to transport electrical charge from one snubber energy storage component (C11, Ci1, Cn1) to the next only in one direction.

4. HV switch unit according to any of the preceding claims, wherein at least one snubber energy storage component (C11, Ci1, Cn1) is a capacitor, in particular all snubber energy storage components (C11, Ci1, Cn1) are capacitors.

5. HV switch unit according to any of the preceding claims, wherein at least one snubber rectifying component (D11, Di1, Dn1) is a diode, in particular all the snubber rectifying components (D11, Di1, Dn1) are diodes.

6. HV switch unit according to any of the preceding claims, wherein the voltage limiting electronic component (Vlimit, Vlimit') comprises a voltage detection component.

7. Pulsing assembly (20) for supplying voltage pulses to a load, in particular a plasma process, the assembly (20) having an input port (21) for connection to a power source and an output port (23) for connection to the load, comprising a first HV switch unit (101) according to any of the preceding claims connected between the input port (21) and the output port (23) and/or a second HV switch unit (102) according to any of the preceding claims connected between the output port (23) and a common port (22), configured to be connected to ground.

8. Pulsing assembly according to preceding claim 7, wherein the pulsing assembly (20) comprises two HV switch units (101, 102) according to any of the preceding claims 1 to 6, connected in series, the series connection connectable to a power source, in particular a DC power source, and the output port (23) is connected to a connection point of the HV switch units (101, 102) and the pulsing assembly (20) is configured to output a pulsed voltage at the output port (23) and to be (?) supplied to a load, for example a plasma load.

9. Method of avoiding voltage imbalances in an HV switch consisting of several semiconductor switches (S1, Si, Sn) connected in series when the HV switch is turned on, comprising the steps of:
a. Connecting in parallel to each semiconductor switch (S1, Si, Sn) a series circuit (2, 3, 4, 2', 3', 4) of a snubber energy storage component (C11, Ci1, Cn1) and a snubber rectifying component (D11, Di1, Dn1),
b. Spreading the excess charge from the energy storage components (C11, Ci1, Cn1) by providing a chain of balancing electronic components parallel to the semiconductor switches (S1, Si, Sn),
c. Limiting the voltage at the beginning or end of the chain by providing a voltage limiting electronic component (Vlimit, Vlimit') in parallel to the snubber energy storage component (C11, Ci1, Cn1) associated with the first or last semiconductor switch (S1, Si, Sn) of the series connected semiconductor switches (S1, Si, Sn)
d. dissipating differential power by providing at least one resistor (R12, Ri2, Rn2) and one inductivity (L12, Li2, Ln2) in the chain.
